# EUROPÄISCHE PATENTANMELDUNG

(11) **EP 1 624 542 A2**
(43) Veröffentlichungstag der Anmeldung: **08.02.2006**
(21) Anmeldenummer: 05090195.8
(22) Anmeldetag: 01.07.2005
(51) Int. Cl.: H01S 5/022, H04B 10/14

(54) **Optoelektronische Anordnung und Verfahren zur Regelung der Ausgangsleistung eines Sendebauelementes**

(30) Priorität: 16.07.2004 US 892777
(71) Anmelder: Infineon Technologies Fiber Optics GmbH, 13629 Berlin (DE)
(72) Erfinder: Hurt, Hans, 93049 Regensburg (DE); Lichtenegger, Thomas, 93087 Alteglofsheim (DE); Prucker, Stephan, 93133 Burglengenfeld (DE)
(74) Vertreter: Müller, Wolfram Hubertus

(57) **Zusammenfassung**

Bezeichnung der Erfindung: Optoelektronische Anordnung und Verfahren zur Regelung der Ausgangsleistung eines Sendebauelementes.

Die Erfindung betrifft eine optoelektronische Anordnung, die aufweist ein Sendebauelement (1), das elektromagnetische Strahlung emittiert, ein Empfangsbauelement (2), das einen Teil der vom Sendebauelement (1) emittierten Strahlung detektiert, und transparentes Material, das das Sendebauelement (1) und das Empfangsbauelement (2) zumindest teilweise umgibt und das eine Grenzfläche (6) der Anordnung gegenüber der Umgebung bereitstellt. Dabei wird ein Teil des vom Sendebauelement (1) emittierten Lichtes im transparenten Material und/oder an der Grenzfläche (6) des transparenten Materials reflektiert und von dem Empfangsbauelement (1) detektiert. Die Erfindung betrifft des weiteren ein Verfahren zur Regelung der Ausgangsleistung eines Sendebauelementes (1) mittels eines Empfangsbauelementes (1), das einen Teil der vom Sendebauelement (1) emittierten Strahlung detektiert.

## Beschreibung

Die Erfindung betrifft eine optoelektronische Anordnung und ein Verfahren zur Regelung der Ausgangsleistung eines Sendebauelementes.

### Hintergrund der Erfindung

Es ist bekannt, dass durch Umgebungseinflüsse wie Temperatur und Alterungseffekte die Ausgangsleistung optischer Sendebauelemente wie beispielsweise von Lumineszenzdioden (LEDs) oder von Laserdioden sich ändert. In der Regel wird jedoch angestrebt, die Ausgangsleistung eines Sendebauelementes möglichst konstant zu halten, um vorgegebene Spezifikationsgrenzen einhalten zu können.

Es ist hierzu bekannt, den Treiberstrom durch ein Sendebauelement durch Variation eines externen Widerstands, der außerhalb des Sendebauelementes angeordnet ist, zu beeinflussen. Der Treiberstrom wird über den Widerstand dabei so eingestellt, dass die Ausgangsleistung eines Sendebauelementes möglichst konstant gehalten wird. Mit einem solchen Aufbau gelingt jedoch nur eine Stabilisierung der Lichtleistung für eng spezifizierte Sendebauelemente mit enger Lichtleistungsverteilung, einer stabilen Alterung und sehr stabilem Temperaturverhalten.

Aus der DE 198 38 350 A1 ist eine optische Sendeeinrichtung bekannt, bei der ein optischer Sender Strahlung vertikal emittiert. Eine Reflektionsfläche reflektiert einen Teil der emittierten Strahlung auf eine optisch sensitive Empfangsfläche eines Monitorempfängers, der auf der Seite des Senders angeordnet ist. Zwischen der Reflektionsfläche und der Empfangszone ist dabei ein Zwischenkörper mit einer reflektierenden Umfangsfläche angeordnet. Dieser Aufbau ist nachteilig relativ aufwendig, das ein gesonderter Zwischenkörper erforderlich ist.

Aus der WO 03/027743 A1 ist eine Sende- und/oder Empfangsanordnung zur optischen Signalübertragung bekannt, bei der eine Basisplatte, ein Sende- und/oder Empfangselement und ein Strahlformungselement derart übereinander angeordnet sind, dass zwischen der Basisplatte und dem Strahlformungselement ein Zwischenraum vorhanden ist, in dem sich das Sende- und/oder Empfangselement befindet. In einer Ausgestaltung ist vorgesehen, dass eine Monitordiode unter oder neben dem Sende- und/oder Empfangselement angeordnet ist. Über eine schräge Grenzfläche im Strahlengang wird ein Teil des Lichtes auf die Monitordiode rückreflektiert.

Es besteht ein Bedarf nach optoelektronischen Anordnungen mit einem Sendebauelement und einem Empfangsbauelement, die in einfacher Weise die Detektion eines Teils des von dem Sendebauelement ausgestrahlten Lichtes durch das Empfangsbauelement ermöglichen.

### Zusammenfassung der Erfindung

Die vorliegende Erfindung stellt eine optoelektronische Anordnung zur Verfügung, die aufweist: ein Sendebauelement, das elektromagnetische Strahlung emittiert, ein Empfangsbauelement, das einen Teil der vom Sendebauelement emittierten Strahlung detektiert, und ein transparentes Material, das das Sendebauelement und das Empfangsbauelement zumindest teilweise umgibt und das eine Grenzfläche der Anordnung gegenüber der Umgebung bereitstellt.

Dabei wird ein Teil des vom Sendebauelement emittierten Lichtes im transparenten Material und/oder an der Grenzfläche des transparenten Materials reflektiert und von dem Empfangsbauelement detektiert. Das Licht breitet sich also zunächst ausgehend von dem Sendebauelement in dem transparentem Material aus und wird dann teilweise an einer Grenzfläche des transparenten Materials reflektiert. Je nach Homogenität des transparenten Materials können kleine Strahlungsanteile auch schon innerhalb des transparenten Materials, also bereits vor Erreichen der Grenzfläche, in Richtung des Empfangsbauelementes gestreut bzw. reflektiert werden. Diese Streung wird umso größer sein, je mehr Inhomogenitäten das transparente Material aufweist, an denen das emittierte Licht streuen kann.

Sofern das transparente Material im Betrieb der Anordnung an ein Material mit gleichem Brechungsindex angrenzt, so dass keine oder fast keine Rückreflexion an der Grenzfläche erfolgt, ist es auch möglich, dass das von dem Empfangsbauelement detektierte Licht allein durch Strahlungsanteile bereitgestellt wird, die innerhalb des Materials durch Streuung in Richtung des Empfangsbauelements gestreut wurden.

Der überwiegende Teil des Lichts tritt durch die Grenzfläche hindurch und wird beispielsweise zwecks einer Datenübertragung in einen Lichtwellenleiter eingekoppelt.

Der vorliegenden Erfindung liegt der Gedanke zugrunde, anhand der Rückreflektion im transparentes Material, insbesondere hervorgerufen durch eine Reflexion an einer Grenzfläche des transparenten Materials, auf die emittierte Lichtleistung des Sendebauelementes rückzuschließen. Die Rückreflektion trifft dabei auf das Empfangsbauelement und bewirkt einen Fotostrom, der direkt proportional zur emittierten Lichtleistung des Sendebauelementes ist. Anhand des Fotostroms kann beispielsweise ein angeschlossener integrierter Schaltkreis den Treiberstrom des Sendebauelementes regeln.

Mittels der vorliegenden Erfindung kann die optische Ausgangsleistung eines Senderbauelements mit engen Grenzen spezifiziert werden. Auch können Sendequellen mit sehr breiten Spezifikationsgrenzen eingesetzt werden. Des weiteren ermöglicht die Erfindung, optische Sendebauelemente auch unter erschwerten Umgebungsbedingungen wie zum Beispiel bei hohen Temperaturen einzusetzen.

Die Erfindung lässt sich kostengünstig realisieren, da in einfacher Weise die Reflektion im und an der Grenzfläche des ohnehin vorhandenen transparenten Materials zur Überwachung der Lichtleistung des Sendebauelements ausgenutzt wird. Die Ausbildung gesonderter reflektierender Strukturen im Strahlengang ist nicht erforderlich.

In einer bevorzugten Ausgestaltung bildet das transparente Material ein Gehäuse (package) der Anordnung. Eine teilweise Reflektion des vom Sendebauelement emittierten Lichtes erfolgt dabei an der Grenzfläche des Gehäuses zur Umgebung, insbesondere an einer oberen ebenen Gehäusebegrenzung, aus der der überwiegende Teil des emittierten Lichts austritt.

Das Sendebauelement ist bevorzugt auf dem Empfangsbauelement angeordnet. Es deckt dabei höchstens einen Teil der fotosensitiven Fläche des Empfangsbauelements ab. Sowohl Sendebauelement als auch Empfangsbauelement sind dabei bevorzugt als vorgefertigter Chip ausgebildet, so dass ein Chip auf Chip Aufbau vorliegt. Der Sendebauelement-Chip ist dabei kleiner als der Empfangsbauelement-Chip. Die gesamte Anordnung ist bevorzugt auf einem Leadframe angeordnet, das bevorzugt ebenfalls von dem transparenten Material umhüllt ist, wobei die Leadframe-Beine aus dem transparenten Material hervorstehen.

In einer ersten Ausgestaltung ist das Empfangsbauelement eine Monitordiode, die ausschließlich dazu eingesetzt ist, einen Teil der vom Sendebauelement emittierten Strahlung zu detektieren. Das Empfangsbauelement erfüllt also allein eine Überwachungsfunktion.

In einer zweiten Ausgestaltung ist das Empfangsbauelement eine Fotodiode, die bei einer bidirektionalen Datenübertragung im Halbduplex-Verfahren im Sendebetrieb als Monitordiode und im Empfangsbetrieb als Empfangs-Fotodiode verwendet wird. Die vorhandenene Fotodiode wird also in effektiver Weise in zweifacher Hinsicht benutzt. Beim Senden des Sendebauelements dient sie der Überwachung der emittierten Lichtleistung. Im Empfangsbetrieb, also bei der Detektion von Signalen, die von einem anderen Sendebauelement ausgesandt und an die Anordnung übertragen werden, dient sie der Signaldetektion. Die zugehörige Elektronik der Anordnung ist in entsprechender Weise ausgelegt, d.h. sie wertet das Signal der Fotodiode in Abhängigkeit davon, ob eine Sendebetrieb oder ein Empfangsbetrieb vorliegt, unterschiedlich aus. Die entsprechenden Zeitschlitze (time slots) sind zu definieren.

Bei dem transparenten Material handelt es sich bevorzugt um ein transparentes Vergussmaterial oder ein transparentes Pressmaterial aus Kunststoff. Es wird als Umhüllung und zum Schutz vor Umwelteinflüssen um die Komponenten der Anordnung gegossen oder gepresst.

Unter einem transparenten Material wird ein Material verstanden, dass jedenfalls für die emittierte Wellenlänge des Sendebauelements transparent ist.

Die Erfindung betrifft auch ein Verfahren zur Regelung der Ausgangsleistung eines Sendebauelementes mittels eines Empfangsbauelementes, das einen Teil der vom Sendebauelement emittierten Strahlung detektiert. Das Verfahren weist die Schritte auf:
- Anordnen des Sendebauelementes und des Empfangsbauelementes zumindest teilweise in einem transparenten Material,
- Detektieren durch das Empfangsbauelement von Strahlung, die vom Sendebauelement abgestrahlt und im transparenten Material und/oder der Grenzfläche des transparenten Materials reflektiert wird,
- Bestimmen der Lichtleistung des Sendebauelementes aus dem Detektionssignal des Empfangsbauelementes;
- Erhöhen oder Verringern des Treiberstroms des Sendebeauelementes, bis die aktuelle Lichtleistung des Sendebauelementes einer Soll-Lichtleistung des Sendebauelementes entspricht.

Die im transparenten Material und an der Grenzfläche reflektierte Strahlung wird im Empfangsbauelement in ein Detektionssignal, den Fotostrom, umgewandelt. Auf der Grundlage des Detektionssignals des Empfangsbauelements wird dann die Lichtleistung des Sendebauelements konstant geregelt. Dies ist möglich, da das Detektionssignal (der Fotostrom) des Empfangsbauelements direkt proportional zur emittierten Lichtleistung des Sendebaueelements ist.

In einer bevorzugten Ausgestaltung wird das Verfahren im Rahmen einer bidirektionalen Datenübertragung im Halbduplex-Verfahren eingesetzt wird, wobei das Empfangsbauelement während des Sendebetriebs als Monitordiode und während des Empfangsbetriebs als Empfangs-Fotodiode verwendet wird.

### Kurze Beschreibung der Zeichnungen

Die Erfindung wird nachfolgend unter Bezugnahme auf die Figuren anhand eines Ausführungsbeispieles näher erläutert. Es zeigen:
- Figur 1: eine optoelektronische Anordnung mit einem Sendebauelement und einem Empfangsbauelement, die in einem Gehäuse aus einem transparenten Vergussmaterial angeordnet sind;
- Figur 2: den Fotostrom des Empfangsbauelementes in Abhängigkeit von der Lichtleistung des Sendebauelementes bei der Anordnung der Figur 1.

### Beschreibung eines bevorzugten Ausführungsbeispiels

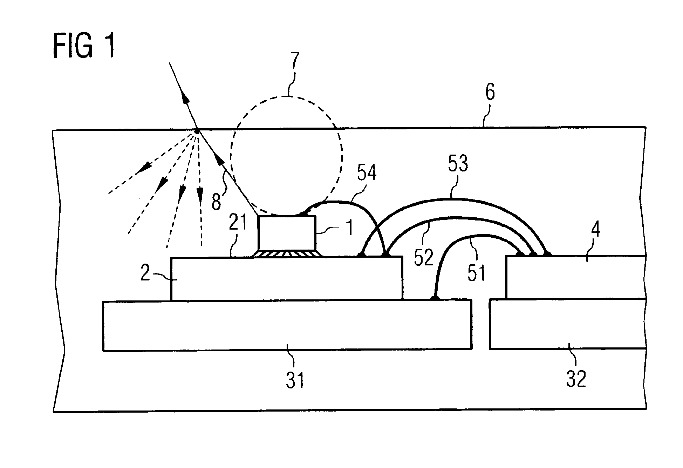

Die Figur 1 zeigt ein Sendebauelement 1, das auf einem Empfangsbauelement 2 angeordnet ist. Bei dem Sendebauelement 1 handelt es sich in dem dargestellten Ausführungsbeispiel um eine Lumineszenzdiode (LED). Ebenfalls kann es sich jedoch auch um eine Laserdiode, beispielsweise einen vertikal emittierenden Laser oder einen Kantenemitter handeln.

Bei dem Empfangsbauelement 2 handelt es sich um eine Fotodiode, die eine optisch sensitive Empfangsfläche 21 zur Detektion elektromagnetischer Strahlung aufweist.

Das Sendebauelement 1 ist ebenso wie das Empfangsbauelement 2 als vorgefertigter Chip ausgebildet. Der LED-Chip 1 ist dabei auf dem Fotodioden-Chip 2 im Rahmen eines Chip-auf-Chip-Aufbaus angeordnet. Der LED-Chip 1 bedeckt dabei höchstens einen Teil der optisch sensitiven Empfangsfläche 21 des Fotodioden-Chips 2.

Die Figur 1 zeigt des Weiteren ein Leadframe 31, auf dem die Fotodiode 2 angeordnet ist sowie einen integrierten Schaltkreis 4, der auf einem weiteren Leadframe 32 angeordnet ist.

Der LED-Chip 1 und der Fotodioden-Chip 2 werden in an sich bekannter Weise mittels Bonddrähten 51 bis 54 kontaktiert. Die Kontaktierung erfolgt jeweils von der Ober- und Unterseite der Chips 1, 2. Die Bonddrähte 51 bis 53 sind dabei mit dem Schaltkreis 4 verbunden und übertragen das Ansteuersignal für den LED-Chip 1 sowie das von dem Fotodioden-Chip 2 erzeugte Stromsignal. Insbesondere wird dem Sendebauelement 1 mittels eines in den Schaltkreise 4 integrierten Treibers ein bestimmter Treiberstrom zugeführt, der die Lichtleistung des Sendebauelementes 1 festlegt. Dabei wird darauf hingewiesen, dass der Treiberbaustein für das Sendebauelement nicht notwendigerweise in den integrierten Schaltkreis 4 integriert sein muss. Er kann auch als gesondertes Bauelement ausgeführt sein.

Die gesamte Anordnung, insbesondere das Sendebauelement 1 und das Empfangsbauelement 2 sind von einem transparenten Verguss- oder Pressmaterial umgeben, das ein Gehäuse der Anordnung bereitstellt. Das Verguss- oder Pressmaterial bildet eine Grenzfläche 6 gegenüber der Umgebung aus, die bevorzugt eben ausgebildet ist.

Das Sendebauelement 1 weist eine bestimmte Abstrahlcharakteristik 7 auf. Eine LED-Diode stellt dabei einen Flächenstrahler mit einer Lambert-Strahlung dar. Das vom Sendebauelement 1 ausgestrahlte Licht wird teilweise an der Grenzfläche 6 gestreut und rückreflektiert, wie in der Figur 1 schematisch anhand eines beispielhaften Lichtstrahls 8 dargestellt. Die Rückreflektion an der Grenzfläche 6 erfolgt aufgrund eines Brechzahlsprungs an der Grenzfläche 6. Geringe Strahlungsteile können auch innerhalb des Package, auf dem Weg bis zur Grenzfläche 6 an Inhomgenitäten reflektiert werden. Auch kann an der Grenzfläche 6 eine Streung an dort vorhandenen Inhomogenitäten erfolgen, die etwa durch eine Rauhheit der Grenzfläche 6 bedingt sind.

Der Begriff Reflektion" wird stellvertretend für alle Mechanismen verwendet, die dazu führen, dass emittiertes Licht auf die Fotodiode 2 reflektiert oder gestreut wird.

Das rückreflektierte Licht wird von der Fotodiode 2 erfasst. Der dabei gemessene Fotostrom ist direkt proportional zur emittierten Lichtleistung des Sendebauelementes 1. Dies bedeutet aber, dass über den Fotostrom in einfacher Weise auf die aktuelle Lichtleistung des Sendebauelementes zurückgeschlossen werden kann. Beispielsweise in dem Schaltkreis 4 wird diese aktuelle Lichtleistung dann mit einer Soll-Lichtleistung verglichen und der Treiberstrom wird hoch- oder heruntergeregelt, bis die aktuelle Lichtleistung der Soll-Lichtleistung entspricht.

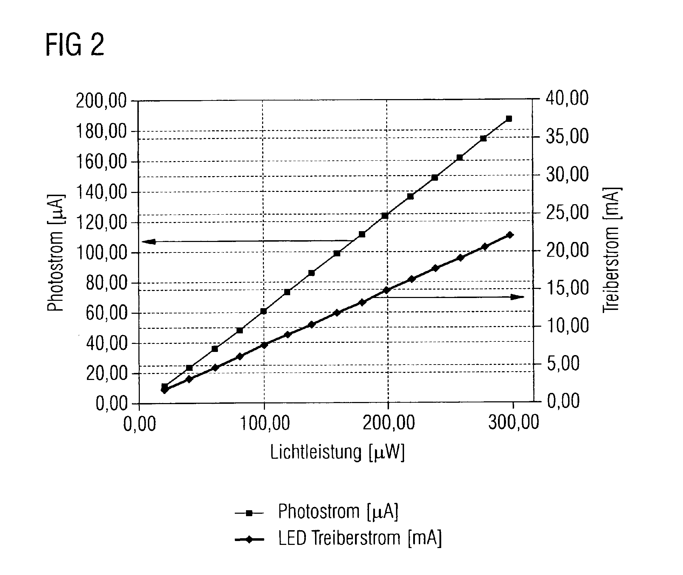

Die Figur 2 zeigt auf der x-Achse die Lichtleistung und auf der y-Achse zum einen den Fotostrom der Fotodiode 2 und zum anderen den Treiberstrom durch den LED-Chip 1 an einem Beispiel. Es liegt ein hochgradig linearer Zusammenhang zwischen der Lichtleistung und dem gemessenen Fotostrom vor (obere Gerade). Wenn der gemessene Fotostrom beispielsweise abnimmt, so bedeutet dies, dass die Lichtleistung des Sendebauelements gesunken ist. Der Treiberstrom wird dann hochgeregelt, bis die Soll-Lichtleistung bzw. ein entsprechender Wert des Fotostroms wieder erreicht ist.

Zur Erfassung von Unterschieden in der Reflektivität der Oberfläche des transparenten Materials, die sich aus Prozessschwankungen bei der Herstellung ergeben können, wird die in Figur 2 dargestellte obere Gerade vor Inbetriebnahme des Sendebauelements bevorzugt kalibriert. Hierzu wird die Lichtleistung des Sendebauelements beispielsweise werksseitig mit anderen Mitteln als der Fotodiode erfasst. Der dabei gemessene Fotostrom stellt einen Punkt der Geraden bereit. Ein zweiter Punkt der Geraden wird durch den Nullpunkt festgelegt.

In einer bevorzugten Ausgestaltung erfolgt ein Einsatz der Anordnung bei einer bidirektionalen Datenübertragung im Halbduplex-Verfahren. Die Fotodiode wird dabei im Sendebetrieb als Monitordiode verwendet, die einen Teil des von dem Sendebauelement emittierten Lichtes empfängt. Im Empfangsbetrieb dient die Fotodiode dagegen als reine Empfangsdiode. Die Verwendung einer zusätzlichen Fotodiode ist daher nicht notwendig.

Eine bevorzugte Anwendung der Erfindung liegt in dem Bereich der Datenübertragung. Dabei gelangt der nicht reflektierte Teil der emittierten Strahlung zu einer nicht dargestellten Ankopplungszone, in der dieser Strahlungsteil in einen Lichtwellenleiter eingekoppelt wird. Bei einer bidirektionalen Datenübertragung wird darüberhinaus Licht aus einem solchen Wellenleiter ausgekoppelt. Eine beispielhafte Anwendung ist die Datenübertratung im Automobilbereich gemäß dem Protokoll byteflight, wobei Daten im Halbduplexverfahren über Plastikfasern übertragen werden. Das Sendebauelement ist dabei als LED Chip ausgebildet.

In einer anderen bevorzugten Anwendung wird die erfindungsgemäße Anordnung für Beleuchtungs- und Hinterleuchtungszwecke eingesetzt.

Die Erfindung beschränkt sich in ihrer Ausgestaltung nicht auf die vorstehend dargestellten Ausführungsbeispiele. Der Fachmann erkennt, dass zahlreiche alternative Ausführungsvarianten existieren, die trotz ihrer Abweichung von den beschriebenen Ausführungsbeispielen von der in den nachfolgenden Ansprüchen definierten Lehre Gebrauch machen.

## Patentansprüche

1. Optoelektronische Anordnung, aufweisend
- ein Sendebauelement (1), das elektromagnetische Strahlung emittiert,
- ein Empfangsbauelement (2), das einen Teil der vom Sendebauelement (1) emittierten Strahlung detektiert,
- ein transparentes Material, das das Sendebauelement (1) und das Empfangsbauelement (2) zumindest teilweise umgibt und das eine Grenzfläche (6) der Anordnung gegenüber der Umgebung bereitstellt,
- wobei ein Teil des vom Sendebauelement (1) emittierten Lichtes im transparenten Material und/oder an der Grenzfläche (6) des transparenten Materials reflektiert und von dem Empfangsbauelement (2) detektiert wird.

2. Anordnung nach Anspruch 1, wobei das transparente Material ein Gehäuse der Anordnung ausbildet und eine teilweise Reflektion des vom Sendebauelement (1) emittierten Lichtes an der Grenzfläche (6) des Gehäuses zur Umgebung erfolgt.

3. Anordnung nach Anspruch 1, wobei das Sendebauelement (1) auf dem Empfangsbauelement (2) angeordnet ist und dabei höchstens einen Teil der fotosensitiven Fläche (21) des Empfangsbauelements (2) abdeckt.

4. Anordnung nach Anspruch 1, wobei das Sendebauelement (1) als vorgefertigter Chip ausgebildet ist.

5. Anordnung nach Anspruch 1, wobei das Empfangsbauelement (2) als vorgefertigter Chip ausgebildet ist.

6. Anordnung nach Anspruch 3, wobei das Empfangsbauelement (21) auf einem Leadframe (31) angeordnet ist.

7. Anordnung nach Anspruch 1, wobei das Empfangsbauelement (2) eine Monitordiode ist, die ausschließlich dazu eingesetzt ist, einen Teil der vom Sendebauelement (1) emittierten Strahlung zu detektieren.

8. Anordnung nach Anspruch 1, wobei das Empfangsbauelement (2) eine Fotodiode ist, die bei einer bidirektionalen Datenübertragung im Halbduplex-Verfahren im Sendebetrieb als Monitordiode und im Empfangsbetrieb als Empfangs-Fotodiode verwendet wird.

9. Anordnung nach Anspruch 1, wobei das transparente Material ein transparentes Vergussmaterial oder ein transparentes Pressmaterial ist.

10. Verfahren zur Regelung der Ausgangsleistung eines Sendebauelementes (1) mittels eines Empfangsbauelementes (2), das einen Teil der vom Sendebauelement (1) emittierten Strahlung detektiert, mit den Schritten:
- Anordnen des Sendebauelementes (1) und des Empfangsbauelementes (2) zumindest teilweise in einem transparenten Material,
- Detektieren durch das Empfangsbauelement (2) von Strahlung, die vom Sendebauelement (1) abgestrahlt und im transparenten Material und/oder der Grenzfläche (6) des transparenten Materials reflektiert wird,
- Bestimmen der Lichtleistung des Sendebauelementes (1) aus dem Detektionssignal des Empfangsbauelementes (2);
- Erhöhen oder Verringern des Treiberstroms des Sendebeauelementes (1), bis die aktuelle Lichtleistung des Sendebauelementes (1) einer Soll-Lichtleistung des Sendebauelementes (1) entspricht.

11. Verfahren nach Anspruch 10, wobei das Verfahren im Rahmen einer bidirektionalen Datenübertragung im Halbduplex-Verfahren eingesetzt wird, und wobei das Empfangsbauelement (2) während des Sendebetriebs als Monitordiode und während des Empfangsbetriebs als Empfangs-Fotodiode verwendet wird.

12. Verfahren nach Anspruch 10, wobei das Verfahren im Rahmen einer unidirektionalen Datenübertragung eingesetzt und das Empfangsbauelement ausschließlich als Monitordiode verwendet wird.
